(19) Europäisches Patentamt
European Patent Office
Office européen des brevets

(11) EP 4 456 372 A1

(12) EUROPEAN PATENT APPLICATION

(43) Date of publication:
30.10.2024 Bulletin 2024/44

(51) International Patent Classification (IPC):
H02J 7/00 (2006.01)   H01M 10/42 (2006.01)

(21) Application number: 23201101.5

(52) Cooperative Patent Classification (CPC):
H02J 7/0069; H01M 10/4285

(22) Date of filing: 01.10.2023

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
KH MA MD TN

(30) Priority: 28.04.2023  CN 202310495452

(71) Applicant: GUANGDONG HYNN TECHNOLOGY CO:, LTD
Dongguan, Guangdong (CN)

(72) Inventors:
• Wang, Liangliang
  Dongguan (CN)
• Xie, Di
  Dongguan (CN)
• Yao, Jigang
  Dongguan (CN)
• Luo, Jianle
  Dongguan (CN)
• Mo, Linzhen
  Dongguan (CN)
• Wu, Yingjin
  Dongguan (CN)
• Zhang, Hao
  Dongguan (CN)
• Wu, Hui
  Dongguan (CN)

(74) Representative: Meyer, Thorsten
Meyer Patentanwaltskanzlei
Pfarrer-Schultes-Weg 14
89077 Ulm (DE)

(54) **TESTING METHOD OF FORMATION AND CAPACITY GRADING, AND ENERGY-SAVING CONTROL SYSTEM FOR FORMATION AND CAPACITY-GRADING TESTING MICROGRID**

(57) A testing method of formation and capacity grading and an energy-saving control system are provided. The method includes obtaining a power of a DC bus at a current moment and a time interval of testing; determining a demand power of the DC bus at a next moment based on a power demand function of a formation testing unit, a power demand function of a capacity-grading testing unit, the power of the DC bus at the current moment and the time interval of testing; and selecting a minimum demand power of the DC bus as an optimization objective to determine a next testing position. The problem of significant energy loss during formation and capacity-grading testing is solved.

FIG. 1

EP 4 456 372 A1

**Description**

FIELD OF THE INVENTION

The present invention relates to the technical field of production and testing of formation and capacity grading for batteries, in particular to a testing method of formation and capacity grading, and an energy-saving control system for a formation and capacity-grading testing microgrid.

BACKGROUND OF THE INVENTION

With the development of energy storage and new energy electric vehicle industries, it's always a recognized key technological challenge in the industry to improve the energy efficiency and safety of the production process of lithium batteries, as key core components. The production process of lithium batteries is divided into three sections: the front, middle, and back sections. The purpose of the front section is to process the raw materials into electrode sheets, with the core process being coating. The middle section aims to process the electrode sheets into inactive battery cells. The back section involves testing and packaging, with the core process being formation and capacity grading. In the production process of lithium batteries, the charging and discharging process of formation and capacity grading is a high-energy-consuming process, and the electrical energy is mostly wasted, which significantly impacts the battery production rate and energy efficiency.

In traditional formation and capacity-grading control schemes, the charging and discharging control power supply consists of distributed low-power AC/DC modules and formation and capacity-grading DC/DC modules, which has high equipment costs and complex wiring. The cells between different testing positions are connected to different AC/DC power supply modules and corresponding formation and capacity-grading DC/DC power supply modules. The energy conversion hierarchy for the cells between testing positions is more, resulting in low energy conversion efficiency and high production electricity costs. The order of sending the cells to the testing positions for formation and capacity grading is fixed, which means that it is unable to calculate the total energy required for formation and capacity grading based on the current position of the already entered cells in the production process, and the determine an optimal testing position as the next testing position while prioritizing production capacity. When the power of the charging and discharging process for the cells is low during formation and capacity grading, the corresponding AC/DC power supply modules are operated in a low-power range, resulting in low energy conversion efficiency. Therefore, the existing technology has the problem of significant energy loss during formation and capacity-grading testing.

SUMMARY OF THE INVENTION

The present invention provides a testing method of formation and capacity grading, and an energy-saving control system for a formation and capacity-grading testing microgrid, which solves the problem of significant energy loss during formation and capacity-grading testing at least.

According to a first aspect of the present invention, a testing method of formation and capacity grading is provided. The testing method includes obtaining a power of a DC bus at a current moment and a time interval of testing; determining a demand power of the DC bus at a next moment based on a power demand function of a formation testing unit, a power demand function of a capacity-grading testing unit, the power of the DC bus at the current moment and the time interval of testing; and selecting a minimum demand power of the DC bus as an optimization objective to determine a next testing position.

Optionally, the testing method further includes determining the time interval of testing based on a ratio of a number of testing channels in any testing position to a cell production capacity, with the cell production capacity referring to a number of cells produced per minute.

Optionally, the testing method further includes when a cell is to be sent to the formation testing unit at the next moment, summing the power of the DC bus at the current moment to a function value of the power demand function of the formation testing unit at the next moment to calculate the demand power of the DC bus at the next moment; when a cell is to be sent to the capacity-grading testing unit at the next moment, summing the power of the DC bus at the current moment to a function value of the power demand function of the capacity-grading testing unit at the next moment to calculate the demand power of the DC bus at the next moment.

Optionally, the testing method further includes when the power of the DC bus at the current moment is greater than or equal to zero, selecting a testing position with a smaller function value between the power demand function of the formation testing unit and the power demand function of the capacity-grading testing unit as the next testing position; when the power of the DC bus at the current moment is less than zero, selecting a testing position with a larger function value between the power demand function of the formation testing unit and the power demand function of the capacity-grading testing unit as the next testing position.

Optionally, the testing method further includes: calculating a power demand function of any testing position in the formation testing unit based on the power demand function of the formation testing unit and a charge-discharge conversion efficiency from any testing position in the formation testing unit to the DC bus; calculating a power demand function of any testing position in the capacity-grading testing unit by multiplying the power demand function of the capacity-grading testing unit and a charge-discharge conversion efficiency from any testing position in the capacity-grading testing unit to the DC bus; when the power of the DC bus at the current moment is greater than or equal to zero, selecting a testing position with a smaller function value between the power demand function of any testing position in the formation testing unit and the power demand function of any testing position in the capacity-grading testing unit as the next testing position; when the power of the DC bus at the current moment is less than zero, selecting a testing position with a larger function value between the power demand function of any testing position in the formation testing unit and the power demand function of any testing position in the capacity-grading testing unit as the next testing position.

According to a second aspect of the present invention, an energy-saving control system for a formation and capacity-grading testing microgrid is provided. The system includes a production logistics scheduling unit configured to issue a testing instruction by using the testing method according to the first aspect of the present invention.

Optionally, the system further includes a formation testing unit, a capacity-grading testing unit, a stacker, a tray, and cells to be tested, wherein the formation testing unit includes multiple formation testing cabinets, the capacity-grading testing unit includes multiple capacity-grading testing cabinets, each of the formation testing cabinets or each of the capacity-grading testing cabinets are provided with multiple testing positions, and the stacker is configured to transport the tray with the cells to be tested to one of the testing positions for testing based on the testing instruction.

Optionally, the system further includes a high-voltage DC power supply unit and a combiner box distribution control unit, wherein the high-voltage DC power supply unit includes multiple energy storage converters, and the combiner box distribution control unit includes multiple breakers and a DC bus, each of the energy storage converters is connected to the DC bus via each of the breakers, and the DC bus is configured to provide a DC power to the multiple formation testing cabinets and the multiple capacity-grading testing cabinets.

Optionally, the production logistics scheduling unit includes a communication module, an energy-saving calculation module, and a data storage module; the communication module is configured for communication and data collection between the formation testing unit, the capacity-grading testing unit, the high-voltage DC power supply unit, the combiner box distribution control unit, and the production logistics scheduling unit; the data storage module is configured to store collected data; the energy-saving calculation module is configured to determine a number of energy storage converters that switch from a normal grid-connected mode to a standby mode in the current time by taking an integer value of a difference between a number of required energy storage converters and a number of energy storage converters in normal grid-connected mode in the current time, and the number of required energy storage converters is a ratio of a total output power of the high-voltage DC power supply unit at the current moment to a rated power of the energy storage converters; and the energy-saving calculation module is further configured to issue the testing instruction.

Optionally, the combiner box distribution control unit further includes multiple formation breakers, multiple capacity-grading breakers, and a cooling fan; the multiple formation breakers and the multiple capacity-grading breakers are configured to connect a corresponding formation testing cabinet and a corresponding capacity-grading testing cabinet to the DC bus; and the cooling fan is configured for ventilation and cooling of the combiner box distribution control unit.

In the embodiments of the present invention, the testing method includes obtaining a power of a DC bus at a current moment and a time interval of testing; determining a demand power of the DC bus at a next moment based on a power demand function of a formation testing unit, a power demand function of a capacity-grading testing unit, the power of the DC bus at the current moment and the time interval of testing; and selecting a minimum demand power of the DC bus as an optimization objective to determine a next testing position. The power demand of the DC bus is smaller, which represents the amount of electric energy obtained from the AC power grid, the energy cycling efficiency of the battery charging and discharging on the DC bus is higher. That is to say, when the formation or capacity-grading unit with the minimum demand power of the DC bus is selected to send into the testing position, the energy loss is reduced and the energy conversion efficiency is improved, thereby solving the problem of high energy loss in formation and capacity-grading testing in related technologies.

In the embodiments of the present invention, the energy circling path between different testing positions in the energy-saving control system for a formation and capacity-grading testing microgrid is changed from AC bus charging and discharging to DC bus charging and discharging, which reduces the energy transfer hierarchy on the charging and discharging path and improves the charge-discharge efficiency of cells between different testing positions.

In the embodiments of the present invention, redundant sleep control technology is used to determine the number of energy storage converters switching from a normal grid-connected mode to a standby mode at the current time, and when the total charging and discharging energy required during the formation and capacity-grading testing process varies, the total input and output energy is concentratedly provided by partial energy storage converters. In such a way, it allows the redundant energy storage converters to take turns in standby modes, enabling the energy conversion state of the energy storage converters in working condition on the DC bus to be maintained at a high level and reducing the average uninterrupted power supply duration for each energy storage converter, thereby improving the service life of the equipment.

In the embodiments of the present invention, a centralized high-voltage high-power energy storage converters is used instead of distributed low-power AC/DC power supplies to provide stable high-voltage DC power to the formation and capacity-grading testing units, the cost of power supplies is reduced and the energy conversion efficiency is improved.

BRIEF DESCRIPTION OF THE DRAWINGS

The figures included in the specification form part of the disclosure and illustrate embodiments of the present invention, which are used together with the specification to explain the principles of the invention.

To provide a clearer description of the embodiments of the present invention or the technical solutions in the prior art, the accompanying drawings that are required in the description of the embodiments or the prior art will be briefly introduced. It is evident that persons ordinary skilled in the art may further obtain additional drawings based on these drawings without inventive contribution.

FIG. 1 is a schematic diagram illustrating a flowchart of a testing method of formation and capacity grading according to an embodiment of the present invention.

FIG. 2 is an overall schematic diagram illustrating an energy-saving control system for a formation and capacity-grading testing microgrid according to an embodiment of the present invention.

FIG. 3 is a schematic diagram illustrating a control flowchart of an energy-saving control system for a formation and capacity-grading testing microgrid according to an embodiment of the present invention.

DETAILED DESCRIPTION OF ILLUSTRATED EMBODIMENTS

To enable those skilled in the art to better understand the present invention, the technical solutions in the embodiments of the present invention will be described clearly and completely in conjunction with the accompanying drawings in the embodiments of the present invention. It is apparent that the described embodiments are merely a part of the embodiments of the present invention, rather than all the embodiments. All other embodiments obtained by persons ordinarily skilled in the art without inventive contribution based on the embodiments in the present invention should also fall within the scope of protection of the present invention.

It should be noted that, in the description of the present invention, the terms "first," "second," etc. are used to distinguish similar objects and are not necessarily used to describe a specific order or sequence. It should be understood that the data used in this way can be interchanged in appropriate circumstances so that the embodiments of the present invention described herein can be implemented in a sequence other than that shown or described herein. Furthermore, the terms "comprising" and "having" and any variations thereof are intended to cover non-exclusive inclusions, such as a process, method, system, product, or apparatus that comprises a series of steps or units does not necessarily include only those steps or units explicitly listed, but may include other steps or units inherent to such process, method, system, product, or apparatus.

The terms "center", "up", "down", "left", "right", "vertical", "horizontal", "inner", "outer", and the like indicating positional relationships or orientations are based on the orientation or positional relationships shown in the drawings for the purpose of describing the present invention and simplifying the description. They should not be interpreted as limitations to the devices or components to specific orientations, constructions, and operations, which should not be understood as limiting the present invention therefore. The terms "installation", "connection" and "coupling" should be broadly interpreted. For example, the related elements may be in fixed connections or detachable connections, in mechanical connections or electrical connections, in direct connections or indirect connections through intermediate media, or in internal connections within two elements, in wireless connections or wired connections. Persons ordinarily skilled in the art can understand the specific meanings of these terms in the context of the present invention.

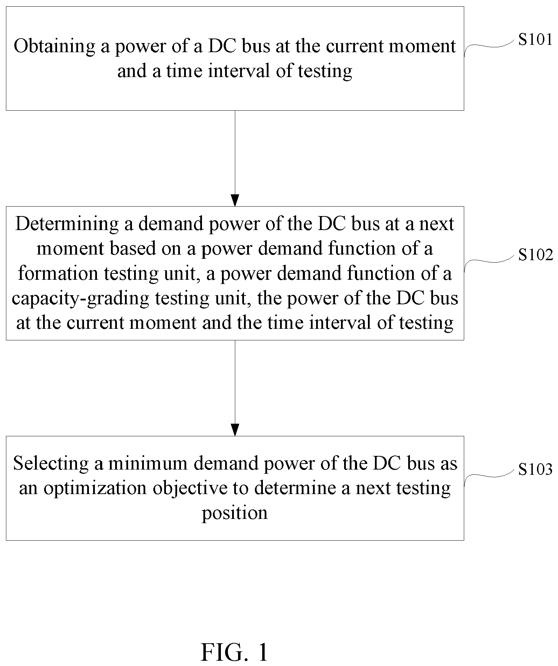

According to the first aspect of the present invention, a testing method of formation and capacity grading is provided. FIG. 1 is a schematic diagram illustrating a flowchart of a testing method of formation and capacity grading according to an embodiment of the present invention, as shown, the testing method includes the following steps:

Step S101, obtaining a power of a DC bus at the current moment and a time interval of testing, optionally, collecting a power on the DC bus in real time as the power of the DC bus at the current moment, wherein such a DC bus is configured to provide direct current for the formation and capacity-grading test;

Step S102, determining a demand power of the DC bus at a next moment based on a power demand function of a formation testing unit, a power demand function of a capacity-grading testing unit, the power of the DC bus at the current moment and the time interval of testing.

Specifically, a formation and capacity-grading production line includes several formation testing cabinets and several capacity-grading testing cabinets, each of the cabinets are provided with multiple testing positions, and the cells to be tested are sent to the testing positions for formation testing or capacity-grading testing. It's assumed that the power of the DC bus at the current moment is $p(t)$, the time interval of testing is $\Delta T$, and the power demand functions of the formation testing unit and the capacity-grading testing unit corresponding to the formation testing process and the capacity-grading testing process of each testing position are represented by $f(t)$ and $g(t)$, respectively. The cells may be sent to a formation testing unit or a capacity-grading testing unit for each testing, therefore, the demand power of the DC bus at the next moment is determined by the sum of the power of the DC bus at the current moment and the power demand function of the formation testing unit $f(t)$ or the power demand function of the capacity-grading testing unit $g(t)$ at the next moment, where the next moment is the current moment plus the time interval of testing.

The testing method further includes Step S103, selecting a minimum demand power of the DC bus as an optimization objective to determine a next testing position. Optionally, the next testing position can be determined based on the power demand of the DC bus at the next moment, as determined in Step S102. Since the current power of the DC bus $p(t)$ is known, the power demand of the DC bus at the next moment can be determined based on the power demand function of the formation testing unit or the capacity-grading testing unit at the next moment. Therefore, the next testing position can be determined by selecting the minimum demand power of the DC bus as an optimization objective.

In the embodiment, the testing method includes obtaining a power of a DC bus at a current moment and a time interval of testing; determining a demand power of the DC bus at a next moment based on a power demand function of a formation testing unit, a power demand function of a capacity-grading testing unit, the power of the DC bus at the current moment and the time interval of testing; and selecting a minimum demand power of the DC bus as an optimization objective to determine a next testing position. The power demand of the DC bus is smaller, which represents the amount of electric energy obtained from the AC power grid, the energy cycling efficiency of the battery charging and discharging on the DC bus is higher. That is to say, when the formation or capacity-grading unit with the minimum demand power of the DC bus is selected to send into the testing position, the energy loss is reduced and the energy conversion efficiency is improved, thereby solving the problem of high energy loss in formation and capacity-grading testing in related technologies.

As an optional embodiment, before obtaining the power of the DC bus at the current moment and the time interval of testing, the testing method may include determining the time interval of testing based on a ratio of a number of testing channels in any testing position to a cell production capacity, with the cell production capacity referring to a number of cells produced per minute. Optionally, it's assumed that the production line produces N cells per minute. Then, the number of cells produced per hour is 60*N. It's assumed that each testing position is provided with M testing channels, the number of the testing positions per hour is 60*N/M, and the time interval of testing for each testing position is 60/(60*N/M), namely $\Delta T$=M/N (minute), where M denotes a number of testing channels and N denotes a cell production capacity.

As an optional embodiment, the step of determining a demand power of the DC bus at a next moment based on a power demand function of a formation testing unit, a power demand function of capacity-grading testing unit, the power of the DC bus at the current moment and the time interval of testing, includes: when a cell is to be sent to the formation testing unit at the next moment, summing the power of the DC bus at the current moment to a function value of the power demand function of the formation testing unit at the next moment to calculate the demand power of the DC bus at the next moment; or when a cell is to be sent to the capacity-grading testing unit at the next moment, summing the power of the DC bus at the current moment to a function value of the power demand function of the capacity-grading testing unit at the next moment to calculate the demand power of the DC bus at the next moment.

Optionally, the power demand functions for the formation and capacity-grading testing processes on the DC bus can be calculated using the following formula:

$$F(t) = \sum_{i=0}^{m-1} f(t + i\Delta T) + \sum_{j=0}^{n-1} g(t + j\Delta T),$$

where m and n denote a total number of testing positions in the formation testing unit and the capacity-grading testing unit, respectively, $f(t)$ represents a power demand function for the formation testing unit, $g(t)$ represents a power demand function for the capacity-grading testing unit, and $\Delta T$ represents a time interval of testing.

Therefore, when a cell is to be sent to the formation testing unit at the next moment, the power demand of the DC bus at the next moment is $F_f(t + \Delta T) = p(t) + f(t + \Delta T)$; when a cell is to be sent to the capacity-grading testing unit at the next moment, the power demand of the DC bus at the next moment is $F_g(t + \Delta T) = p(t) + g(t + \Delta T)$, where $p(t)$ represents the power demand of the DC bus at the current moment.

As an optional embodiment, the step of selecting a minimum demand power of the DC bus as an optimization objective to determine a next testing position includes: when the power of the DC bus at the current moment is greater than or equal to zero, selecting a testing position with a smaller function value between the power demand function of the formation testing unit and the power demand function of the capacity-grading testing unit as the next testing position; or when the power of the DC bus at the current moment is less than zero, selecting a testing position with a larger function value between the power demand function of the formation testing unit and the power demand function of the capacity-grading testing unit as the next testing position.

It's understood that, when the demand power of the DC bus is minimized, the optimal energy cycling control is achieved. The following formula can be used to calculate the demand power of the DC bus $F(t)$, taking the initial testing process of the formation and capacity-grading testing unit as an example:

$$F(t)=\begin{cases} p(t)+\min\{f(t_0),g(t_0)\}, & p(t)\geq 0 \\ p(t)+\max\{f(t_0),g(t_0)\}, & p(t)<0 \end{cases};$$

where $p(t)$ represents a power of the DC bus at the current moment, $f(t_0)$ and $g(t_0)$ represent a power required for the initial testing process of the formation and capacity-grading testing units respectively. When $p(t)\geq 0$, indicating that the discharge cells have more power than the charging cells, and there is surplus power on the DC bus. Therefore, a testing position of charging, or a testing position with lower discharging power may be selected for the next testing. It can be understood that, the voltage and current directions in the charging cells are opposite, thus the power demand function value for the charging testing position is negative. That's, when $p(t)\geq 0$, a testing position corresponding to the smallest value in the set $\{f(t_0),g(t_0)\}$ is determined as the next testing position. Conversely, when $p(t)<0$, a testing position corresponding to the largest value in the set $\{f(t_0),g(t_0)\}$ is determined as the next testing position, thus achieving the highest efficiency of charge-discharge cycling.

As an optional embodiment, the step of selecting a minimum demand power of the DC bus as an optimization objective to determine a next testing position further includes: calculating a power demand function of any testing position in the formation testing unit based on the power demand function of the formation testing unit and a charge-discharge conversion efficiency from any testing position in the formation testing unit to the DC bus; calculating a power demand function of any testing position in the capacity-grading testing unit by multiplying the power demand function of the capacity-grading testing unit and a charge-discharge conversion efficiency from any testing position of the capacity-grading testing unit to the DC bus; when the power of the DC bus at the current moment is greater than or equal to zero, selecting a testing position with a smaller function value between the power demand function of any testing position in the formation testing unit and the power demand function of any testing position in the capacity-grading testing unit as the next testing position; or when the power of the DC bus at the current moment is less than zero, selecting a testing position with a larger function value between the power demand function of any testing position in the formation testing unit and the power demand function of any testing position in the capacity-grading testing unit as the next testing position.

Optionally, considering the charge-discharge conversion efficiency of different testing positions to the DC bus, there may be differences in the conversion efficiency due to the different lengths of the cables connecting the different testing positions to the DC bus. Specifically, the testing positions with shorter cable lengths have higher charge-discharge conversion efficiency, while the testing positions with longer cable lengths have lower charge-discharge conversion efficiency. By multiplying the power demand function of the formation testing unit or the capacity-grading testing unit by the charge-discharge conversion efficiency of the testing position, a power demand function of the formation testing unit or the capacity-grading testing unit in any testing position may be obtained, and the specific formula is as follows:

$$\begin{cases} f'(t)=f(t)*\eta_f(m) \\ g'(t)=g(t)*\eta_g(n) \end{cases};$$

where m and n represent a total number of testing positions in the formation testing units and the capacity-grading testing units, $\eta_f(m)$ represents a conversion efficiency function of any testing position in the formation testing unit, and $\eta_g(n)$ represents a conversion efficiency function of any testing position in the capacity-grading testing unit. Based on this, the power demand of the DC bus is minimized, and the steps and methods described in the previous embodiment may be referred.

According to the second aspect of the present invention, an energy-saving control system for a formation and capacity-grading testing microgrid is provided. The system includes a production logistics scheduling unit configured to issue a testing instruction by using the testing method according to the first aspect of the present invention. Optionally, in the embodiment, the production logistics scheduling unit of the system can collect the power of the DC bus in real-time in the scenario of formation and capacity-grading testing for battery cells, and determine the optimal testing position for cell entry at the next moment based on the minimum demand power of the DC bus. The power demand of the DC bus is smaller, which represents the amount of electric energy obtained from the AC power grid, the energy cycling efficiency of the battery charging and discharging on the DC bus is higher. That is to say, when the formation or capacity-grading unit with the minimum demand power of the DC bus is selected to send into the testing position, the energy loss is reduced and the energy conversion efficiency is improved, the demand power and energy peak value of the DC bus can be reduced, the capacity of the energy storage PCS configuration can be reduced, and the production electricity cost in the factory area can be lowered, thereby solving the problem of high energy loss in formation and capacity-grading testing in related technologies.

As an optional embodiment, the system further includes a formation testing unit, a capacity-grading testing unit, a stacker, a tray, and cells to be tested. The formation testing unit includes multiple formation testing cabinets, the capacity-grading testing unit includes multiple capacity-grading testing cabinets, each of the formation testing cabinets or each of the capacity-grading testing cabinets are provided with multiple testing positions, and the stacker is configured to transport the tray with the cells to one of the testing positions for testing based on the testing instruction. Optionally, a formation and capacity-grading production line includes multiple formation cabinets and multiple capacity-grading cabinets, and each formation cabinet includes a corresponding formation DC/DC power supply and cells to be tested, and each capacity-grading cabinet includes a corresponding capacity-grading DC/DC power supply and cells to be tested. Each formation cabinet or each capacity-grading cabinet is provided with multiple test positions, and each testing position is provided with multiple testing channels. The cells to be tested are fixed on the tray in the corresponding testing channels, and the tray are sequentially sent to the testing positions in the formation and capacity-grading cabinets by the stacker according to the testing instructions.

As an optional embodiment, the system also includes a high-voltage DC power supply unit and a combiner box distribution control unit. The high-voltage DC power supply unit includes multiple energy storage converters, and the combiner box distribution control unit includes multiple breakers and a DC bus. Each of the energy storage converters is connected to the DC bus via each of the breakers, and the DC bus is configured to provide a DC power to the multiple formation testing cabinets and the multiple capacity-grading testing cabinets. Optionally, the multiple energy storage inverters are connected to the DC bus through the corresponding breakers to provide stable high-voltage DC power to the DC bus. The DC bus delivers the high-voltage DC power to the formation testing cabinets in the formation testing unit and the capacity-grading testing cabinets in the capacity-grading testing unit. The connection or disconnection between the multiple energy storage inverters and the DC bus can be controlled by the corresponding breakers.

As an optional embodiment, the production logistics scheduling unit includes a communication module, an energy-saving calculation module, and a data storage module. The communication module is configured for communication and data collection between the formation testing unit, the capacity-grading testing unit, the high-voltage DC power supply unit, the bus distribution control unit, and the production logistics scheduling unit. The data storage module is configured to store the collected data. The energy-saving calculation module is configured to determine a number of energy storage converters that switch from a normal grid-connected mode to a standby mode in the current time by taking an integer value of a difference between a number of required energy storage converters and a number of energy storage converters in normal grid-connected mode in the current time, and the number of required energy storage converters is a ratio of a total output power of the high-voltage DC power supply unit at the current moment to a rated power of the energy storage converters. The energy-saving calculation module is further configured to issue the testing instruction by using the testing method according to the first aspect of the present invention.

Optionally, the communication module is configured to establish communication connections with the high-voltage DC power supply unit, the formation testing unit, and the capacity-grading testing unit, respectively, to perform data acquisition and control command issuance to the corresponding units. Based on the power data information on the DC bus uploaded by the high-voltage DC power supply unit and the formation and capacity-grading testing information, the energy-saving calculation module may issue redundant standby shutdown instructions to the high-voltage DC power supply unit, i.e., the energy storage inverters, or issue testing instructions to the formation and capacity-grading testing units. The number of energy storage inverters that should switch from the normal grid-connected mode to the standby mode at the current time can be determined by the following formula:

$$m(t) = floor\left(n - p(t)/P_n\right);$$

where $n$ denotes a number of energy storage inverters in the normal grid-connected mode at the current time, $p(t)$ represents a total output power of the high-voltage DC power supply unit, $P_n$ represents the rated power of the energy storage inverters, and $floor(\ )$ represents a floor function. In other words, when $n - p(t)/P_n < k$, the number of energy storage converters that switch from the normal grid-connected mode to the standby mode is k-1, which ensures that the energy storage converters can work at the highest energy conversion efficiency without overloading.

As an optional embodiment, the combiner box distribution control unit further includes multiple formation breakers, multiple capacity-grading breakers, and a cooling fan. The multiple formation breakers and the multiple capacity-grading breakers are configured to connect a corresponding formation testing cabinets and capacity-grading testing cabinet to the DC bus, and the cooling fan is configured for ventilation and cooling of the combiner box distribution control unit. Optionally, the multiple formation cabinets in the formation testing unit are connected to the DC bus through corresponding formation breakers. Similarly, the multiple capacity-grading cabinets in the capacity-grading testing unit are connected to the DC bus through corresponding capacity breakers. The multiple formation breakers and multiple capacity breakers can control the electrical connection and disconnection between the formation cabinets and capacity-grading cabinets and the DC bus, which is convenient for maintenance and repair of partial equipment or circuits while the production line is running normally. Since the DC bus may generate significant heat when the current is high, thus the cooling fan inside the bus distribution control unit is necessary to dissipate the heat.

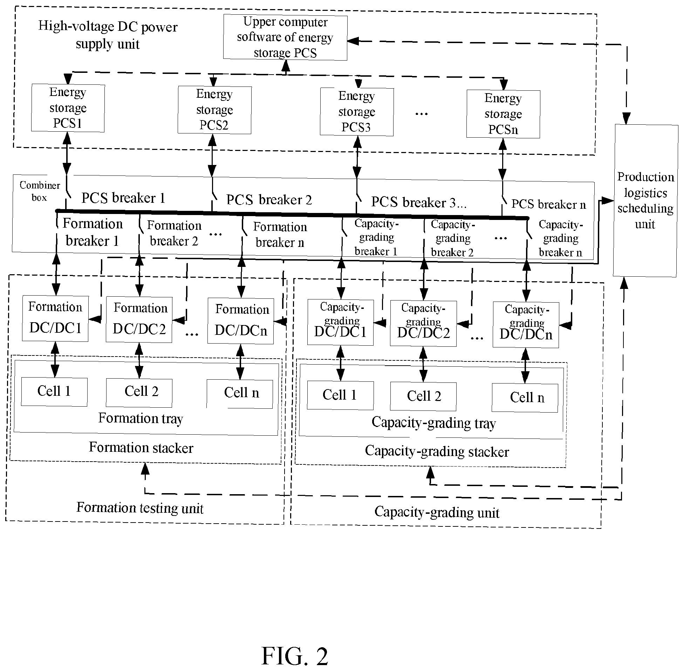

As an optional embodiment, FIG. 2 is a schematic diagram of an energy-saving control system for a formation and capacity-grading testing microgrid according to embodiments of the present invention. As shown in FIG. 2, the high-voltage DC power supply unit includes multiple high-voltage high-power energy storage PCS (energy storage PCS1...energy storage PCSn). Each energy storage PCS is configured to establish an electrical connection with the DC bus through the corresponding PCS breaker in the combiner box distribution control unit, and communicate with the production logistics scheduling unit through upper computer software of the energy storage PCS for data sampling and switch control commands. The combiner box distribution control unit, i.e., the combiner box, includes multiple energy storage PCS breakers, multiple formation breakers (formation breaker 1... formation breaker n), multiple capacity-grading breakers (capacity-grading breaker 1...capacity-grading breaker n), a DC bus, and a cooling fan. The energy storage PCS breakers are configured to control the connection or disconnection between the corresponding PCS DC output side and the DC bus, and the formation and capacity-grading breakers are configured to control the connection or disconnection between the corresponding formation testing unit or capacity-grading testing unit and the DC bus, which facilitates the maintenance and repair of partial equipment or circuits under normal production line operation.

The formation testing unit includes multiple chemical formation testing cabinets (including formation DC/DC converters), formation stackers, trays, and cells to be tested (cell 1...cell n). The formation stackers and formation DC/DC converters communicate with the production logistics scheduling unit through a local area network. The production logistics scheduling unit can send test process instructions to the formation DC/DC converters and send testing instructions to the stackers, so that the stackers can place the trays with the cells into the designated testing position for the corresponding formation testing. The capacity testing unit functions similarly. The production logistics scheduling unit includes a communication module, an energy-saving calculation module, and a data storage module. The communication module is configured to establish communication connections with the high-voltage DC power supply unit, the formation testing unit, and the capacity-grading testing unit, and collect data and send control commands to the corresponding units. Based on the power data uploaded from the DC bus and the corresponding formation and capacity-grading testing process, in combination with energy-saving optimization control algorithms, the energy-saving calculation module may send the redundant standby shutdown instructions to the high-voltage DC power supply unit, or testing instructions to the formation and capacity-grading testing units.

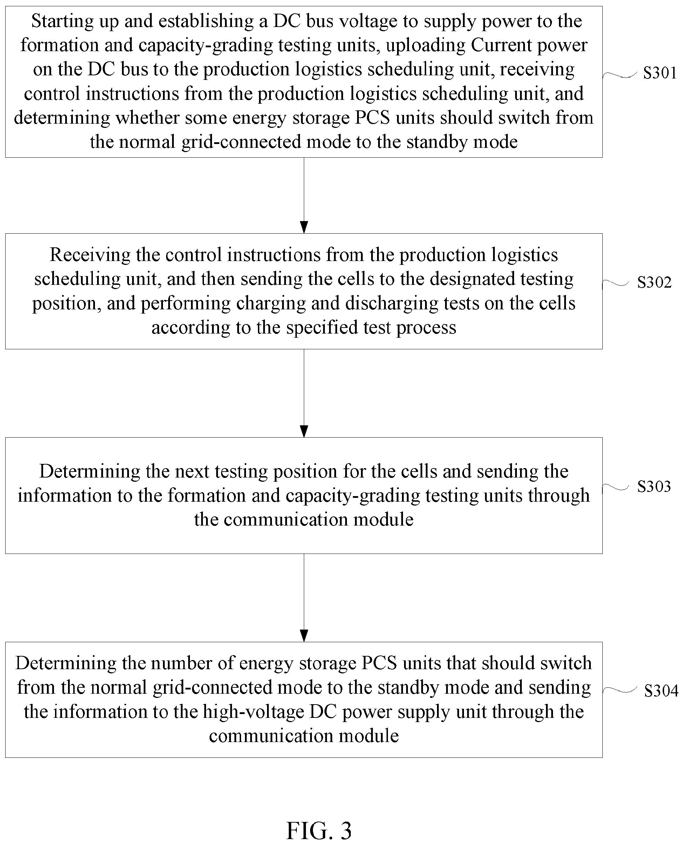

As an optional embodiment, FIG. 3 is a schematic diagram illustrating a control flowchart of an energy-saving control system for a formation and capacity-grading testing microgrid according to embodiments of the present invention. As shown, the control process of the system may include the following steps.

Step S301, after the system is powered on, the DC power supply unit starts up and establishes a DC bus voltage to supply power to the formation and capacity-grading testing units, and the current power on the DC bus is uploaded to the production logistics scheduling unit, meanwhile the control instructions from the production logistics scheduling unit are received, and it's determined whether some energy storage PCS units should switch from the normal grid-connected mode to the standby mode.

Step S302, the formation and capacity-grading testing units receive the control instructions from the production logistics scheduling unit, and then the stacker sends the cells to the designated testing position, and the formation DC/DC converter performs charging and discharging tests on the cells according to the specified test process.

Step S303, the energy-saving calculation module of the production logistics scheduling unit determines the next testing position for the cells and sends the information to the formation and capacity-grading testing units through the communication module. Specifically, the next testing position for the cells can be determined using the following formula:

$$F\left(t+\Delta T\right)=\begin{cases} p\left(t\right)+\min\left\{f\left(t+\Delta T\right),g\left(t+\Delta T\right)\right\}, & p\left(t\right)\geq 0 \\ p\left(t\right)+\max\left\{f\left(t+\Delta T\right),g\left(t+\Delta T\right)\right\}, & p\left(t\right)<0 \end{cases}.$$

Step S304, the energy-saving calculation module of the production logistics scheduling unit determines the number of energy storage PCS units that should switch from the normal grid-connected mode to the standby mode and sends the information to the high-voltage DC power supply unit through the communication module. Optionally, the number of energy storage PCS units switched to the standby mode can be determined using the following formula:

$$m(t) = floor\left(n - p(t)/P_{\mathrm{n}}\right).$$

In the embodiment of the present invention, the energy circling path between different testing positions in the energy-saving control system for a formation and capacity-grading testing microgrid is changed from AC bus charging and discharging to DC bus charging and discharging, which reduces the energy transfer hierarchy on the charging and discharging path and improves the charge-discharge efficiency of cells between different testing positions. By using redundant sleep control technology, the number of energy storage converters switching from a normal grid-connected mode to a standby mode at the current time is determined, and when the total charging and discharging energy required during the formation and capacity-grading testing process varies, the total input and output energy is concentratedly provided by partial energy storage converters. In such a way, it allows the redundant energy storage converters to take turns in standby modes, enabling the energy conversion state of the energy storage converters in working condition on the DC bus to be maintained at a high level and reducing the average uninterrupted power supply duration for each energy storage converter, thereby improving the service life of the equipment. By using centralized high-voltage high-power energy storage converters instead of distributed low-power AC/DC power supplies to provide stable high-voltage DC power to the formation and capacity-grading testing units, the cost of power supplies is reduced and the energy conversion efficiency is improved.

The above description is only preferred embodiments of the present invention. It should be pointed out that those skilled in the art can make various improvements and modifications without departing from the principles of the present invention, and these improvements and modifications should also be regarded as within the scope of the present invention.

## Claims

1.    A testing method of formation and capacity grading, comprising:

   obtaining a power of a DC bus at a current moment and a time interval of testing;
   determining a demand power of the DC bus at a next moment based on a power demand function of a formation testing unit, a power demand function of a capacity-grading testing unit, the power of the DC bus at the current moment and the time interval of testing; and
   selecting a minimum demand power of the DC bus as an optimization objective to determine a next testing position.

2.    The testing method according to claim 1, before said obtaining a power of a DC bus at a current moment and a time interval of testing, further comprising:
   determining the time interval of testing based on a ratio of a number of testing channels in any testing position to a cell production capacity, with the cell production capacity referring to a number of cells produced per minute.

3.    The testing method according to claim 1, wherein said determining a demand power of the DC bus at a next moment based on a power demand function of a formation testing unit, a power demand function of capacity-grading testing unit, the power of the DC bus at the current moment and the time interval of testing, comprises:

   when a cell is to be sent to the formation testing unit at the next moment, summing the power of the DC bus at the current moment to a function value of the power demand function of the formation testing unit at the next moment to calculate the demand power of the DC bus at the next moment;
   when a cell is to be sent to the capacity-grading testing unit at the next moment, summing the power of the DC bus at the current moment to a function value of the power demand function of the capacity-grading testing unit at the next moment to calculate the demand power of the DC bus at the next moment.

4.    The testing method according to claim 3, wherein said selecting a minimum demand power of the DC bus as an optimization objective to determine a next testing position comprises:

when the power of the DC bus at the current moment is greater than or equal to zero, selecting a testing position with a smaller function value between the power demand function of the formation testing unit and the power demand function of the capacity-grading testing unit as the next testing position;
when the power of the DC bus at the current moment is less than zero, selecting a testing position with a larger function value between the power demand function of the formation testing unit and the power demand function of the capacity-grading testing unit as the next testing position.

5. The testing method according to claim 3, wherein said selecting a minimum demand power of the DC bus as an optimization objective to determine a next testing position further comprises:

calculating a power demand function of any testing position in the formation testing unit based on the power demand function of the formation testing unit and a charge-discharge conversion efficiency from any testing position in the formation testing unit to the DC bus;
calculating a power demand function of any testing position in the capacity-grading testing unit by multiplying the power demand function of the capacity-grading testing unit and a charge-discharge conversion efficiency from any testing position in the capacity-grading testing unit to the DC bus;
when the power of the DC bus at the current moment is greater than or equal to zero, selecting a testing position with a smaller function value between the power demand function of any testing position in the formation testing unit and the power demand function of any testing position in the capacity-grading testing unit as the next testing position;
when the power of the DC bus at the current moment is less than zero, selecting a testing position with a larger function value between the power demand function of any testing position in the formation testing unit and the power demand function of any testing position in the capacity-grading testing unit as the next testing position.

6. An energy-saving control system for a formation and capacity-grading testing microgrid, comprising a production logistics scheduling unit configured to issue a testing instruction by using the testing method according to any one of claims 1 to 5.

7. The system according to claim 6, further comprising a formation testing unit, a capacity-grading testing unit, a stacker, a tray, and cells to be tested, wherein the formation testing unit comprises multiple formation testing cabinets, the capacity-grading testing unit comprises multiple capacity-grading testing cabinets, each of the formation testing cabinets or each of the capacity-grading testing cabinets are provided with multiple testing positions, and the stacker is configured to transport the tray with the cells to be tested to one of the testing positions for testing based on the testing instruction.

8. The system according to claim 7, further comprising a high-voltage DC power supply unit and a combiner box distribution control unit, wherein the high-voltage DC power supply unit comprises multiple energy storage converters, and the combiner box distribution control unit comprises multiple breakers and a DC bus, each of the energy storage converters is connected to the DC bus via each of the breakers, and the DC bus is configured to provide a DC power to the multiple formation testing cabinets and the multiple capacity-grading testing cabinets.

9. The system according to claim 8, wherein the production logistics scheduling unit comprises a communication module, an energy-saving calculation module, and a data storage module; the communication module is configured for communication and data collection between the formation testing unit, the capacity-grading testing unit, the high-voltage DC power supply unit, the combiner box distribution control unit, and the production logistics scheduling unit; the data storage module is configured to store collected data; the energy-saving calculation module is configured to determine a number of energy storage converters that switch from a normal grid-connected mode to a standby mode in the current time by taking an integer value of a difference between a number of required energy storage converters and a number of energy storage converters in normal grid-connected mode in the current time, and the number of required energy storage converters is a ratio of a total output power of the high-voltage DC power supply unit at the current moment to a rated power of the energy storage converters; and the energy-saving calculation module is further configured to issue the testing instruction.

10. The system according to claim 9, wherein the combiner box distribution control unit further comprises multiple formation breakers, multiple capacity-grading breakers, and a cooling fan; the multiple formation breakers and the multiple capacity-grading breakers are configured to connect a corresponding formation testing cabinet and a corresponding capacity-grading testing cabinet to the DC bus; and the cooling fan is configured for ventilation and cooling of the combiner box distribution control unit.

Obtaining a power of a DC bus at the current moment and a time interval of testing — S101

Determining a demand power of the DC bus at a next moment based on a power demand function of a formation testing unit, a power demand function of a capacity-grading testing unit, the power of the DC bus at the current moment and the time interval of testing — S102

Selecting a minimum demand power of the DC bus as an optimization objective to determine a next testing position — S103

FIG. 1

FIG. 2

Starting up and establishing a DC bus voltage to supply power to the formation and capacity-grading testing units, uploading Current power on the DC bus to the production logistics scheduling unit, receiving control instructions from the production logistics scheduling unit, and determining whether some energy storage PCS units should switch from the normal grid-connected mode to the standby mode

— S301

Receiving the control instructions from the production logistics scheduling unit, and then sending the cells to the designated testing position, and performing charging and discharging tests on the cells according to the specified test process

— S302

Determining the next testing position for the cells and sending the information to the formation and capacity-grading testing units through the communication module

— S303

Determining the number of energy storage PCS units that should switch from the normal grid-connected mode to the standby mode and sending the information to the high-voltage DC power supply unit through the communication module

— S304

FIG. 3

Europäisches
Patentamt

European
Patent Office

Office européen
des brevets

# EUROPEAN SEARCH REPORT

**Application Number**

EP 23 20 1101

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2020/186653 A1 (REPOWER TECH CO LTD [CN]) 24 September 2020 (2020-09-24) | 1,2,6-10 | INV.<br>H02J7/00<br>H01M10/42 |
| A | * paragraphs [0085], [0086], [0101], [0102]; claim 1; figures 1, 3 *<br>----- | 3-5 | |

**TECHNICAL FIELDS SEARCHED (IPC)**

H02J
H01M

The present search report has been drawn up for all claims

| Place of search | Date of completion of the search | Examiner |
|---|---|---|
| Munich | 27 March 2024 | Sulic, Tomislav |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..................................................................................
& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 23 20 1101

This annex lists the patent family members relating to the patent documents cited in the above-mentioned European search report.
The members are as contained in the European Patent Office EDP file on
The European Patent Office is in no way liable for these particulars which are merely given for the purpose of information.

27-03-2024

| Patent document cited in search report | | Publication date | Patent family member(s) | | Publication date |
|---|---|---|---|---|---|
| WO 2020186653 | A1 | 24-09-2020 | CN | 111711253 A | 25-09-2020 |
| | | | WO | 2020186653 A1 | 24-09-2020 |

EPO FORM P0459

For more details about this annex : see Official Journal of the European Patent Office, No. 12/82